(19) Europäisches Patentamt / European Patent Office / Office européen des brevets

(11) **EP 4 109 766 B1**

(12) **EUROPEAN PATENT SPECIFICATION**

(45) Date of publication and mention
of the grant of the patent:
**01.10.2025 Bulletin 2025/40**

(21) Application number: **21781171.0**

(22) Date of filing: **01.03.2021**

(51) International Patent Classification (IPC):
*H03M 13/13* (2006.01)    *H03M 13/23* (2006.01)
*H03M 13/29* (2006.01)    *H04L 1/00* (2006.01)

(52) Cooperative Patent Classification (CPC):
**H03M 13/13; H03M 13/23; H03M 13/2933;
H04L 1/0041; H04L 1/0057; H04L 1/0059;
H04L 1/0065**

(86) International application number:
**PCT/CN2021/078435**

(87) International publication number:
**WO 2021/196942 (07.10.2021 Gazette 2021/40)**

(54) **ENCODING METHOD AND DEVICE**

CODIERUNGSVERFAHREN UND -VORRICHTUNG

PROCÉDÉ ET DISPOSITIF DE CODAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.03.2020 CN 202010246462**

(43) Date of publication of application:
**28.12.2022 Bulletin 2022/52**

(73) Proprietor: **Huawei Technologies Co., Ltd.
Shenzhen, Guangdong 518129, (CN)**

(72) Inventors:
• **DAI, Shengchen**
  **Shenzhen, Guangdong 518129 (CN)**
• **ZHANG, Huazi**
  **Shenzhen, Guangdong 518129 (CN)**
• **WANG, Xianbin**
  **Shenzhen, Guangdong 518129 (CN)**
• **TONG, Jiajie**
  **Shenzhen, Guangdong 518129 (CN)**
• **LI, Rong**
  **Shenzhen, Guangdong 518129 (CN)**
• **WANG, Jun**
  **Shenzhen, Guangdong 518129 (CN)**

(74) Representative: **Isarpatent
Patent- und Rechtsanwälte Barth
Charles Hassa Peckmann & Partner mbB
Friedrichstrasse 31
80801 München (DE)**

(56) References cited:
CN-A- 102 468 856    CN-A- 103 746 708
CN-A- 106 888 025    US-A1- 2015 295 593

• XIAO, FEI [ET AL.]: "A novel coded modulation
  scheme based on Polar code", PROC. ASIA
  COMMUNICATIONS AND PHOTONICS
  CONFERENCE (ACP) 2017, SU1B.5, 10
  November 2017 (2017-11-10), pages 1 - 3,
  XP033523285
• USMAN, MOHAMMED: "Concatenated
  convolution-Polar codes over Rayleigh channels
  degraded as erasure channels", PROC. 10TH
  INTERNATIONAL CONFERENCE ON
  INTELLIGENT SYSTEMS AND CONTROL (ISCO)
  2016, 7 January 2016 (2016-01-07), pages 1 - 5,
  XP032989283, DOI: 10.1109/ISCO.2016.7727053
• MA, H.H. [ET AL.]: "On tail biting convolutional
  codes", IEEE TRANSACTIONS ON
  COMMUNICATIONS, vol. COM-34, no. 2, 1
  February 1986 (1986-02-01), pages 104 - 111,
  XP002038443, ISSN: 0090-6778, DOI: 10.1109/
  TCOM.1986.1096498

- MAO, YINYOU [ET AL.]: "Serially concatenated scheme of polar codes and the improved belief propagation decoding algorithm", IET COMMUNICATIONS, THE INSTITUTION OF ENGINEERING AND TECHNOLOGY, GB, vol. 14, no. 14, 25 August 2020 (2020-08-25), pages 2309 - 2318, XP006091690, ISSN: 1751-8628, DOI: 10.1049/IET-COM.2019.0887
- FENG BOWEN ET AL: "On Tail-Biting Polarization-Adjusted Convolutional (TB-PAC) Codes and Small-Sizes List Decoding", IEEE COMMUNICATIONS LETTERS., vol. 27, no. 2, 1 February 2023 (2023-02-01), US, pages 433 - 437, XP093275990, ISSN: 1089-7798, Retrieved from the Internet <URL:https://ieeexplore.ieee.org/stampPDF/getPDF.jsp?tp=&arnumber=9964378&ref=aHR0cHM6Ly9pZWVleHBsb3JlLmllZWWUub3JnL2Fic3RyYWN0L2RvY3VtZW50Lzk5NjQzNzgvYXV0aG9ycw==> DOI: 10.1109/LCOMM.2022.3225177
- LIU ZHENZHEN ET AL: "Adding a Rate-1 Third Dimension to Parallel Concatenated Systematic Polar Code: 3D Polar Code", WIRELESS COMMUNICATIONS AND MOBILE COMPUTING, vol. 2018, no. 1, 1 January 2018 (2018-01-01), pages 1 - 6, XP093276029, ISSN: 1530-8669, Retrieved from the Internet <URL:https://onlinelibrary.wiley.com/doi/pdfdirect/10.1155/2018/8928761> DOI: 10.1155/2018/8928761

Description

## TECHNICAL FIELD

This disclosure relates to the field of communication technologies, and the invention, in particular, relates to an encoding method and apparatus.

## BACKGROUND

In a communication system, channel encoding (forward error correction, FEC)/decoding is gene rally used to improve data transmission reliability and ensure communication quality. Polar code (Polar codes) proposed by the Turkish professor Arikan is the first good code that theoretically achieves a Shannon capacity and has low encoding/decoding complexity. Therefore, the polar code has a good development and application prospect.

An encoding process of the polar code is x = u · $F_n$, where u is a binary vector whose length is n, and $F_n$ is a Kronecker (Kronecker) transformation matrix, and is also a generation matrix G of the polar code. $F_n = \begin{bmatrix} 1 & 0 \\ 1 & 1 \end{bmatrix}^{\otimes n}$ is a Kronecker product of n matrices $\begin{bmatrix} 1 & 0 \\ 1 & 1 \end{bmatrix}$. A polarization phenomenon occurs on code generated by using the method, and decoding may be performed by using a successive cancellation (successive cancellation, SC) decoding method.

However, decoding performance of an existing polar encoding method needs to be improved.

A paper by Xiao, Fei Et Al. "A novel coded modulation scheme based on polar code" relates to a coded modulation scheme based on the Polar code. The novel coded modulation scheme combines the advantages of both polar code and trellis-coded modulation. Under the same BER, the novel coded modulation scheme requires lower SNR and coding complexity and can achieve channel capacity closer to tolerance to the Shannon limit.

A paper by Mohammed Usman "Concatenated convolution-polar codes over rayleigh channels degraded as erasure channels" relates to a method to apply polar codes over wireless channels. The performance of polar codes over typical urban fading wireless channels is investigated. The wireless channel is modeled as a degraded erasure channel using an inner convolution code and interleaving. When the convolution code fails to correct errors, the corresponding bits are discarded and treated as erasures. The performance of polar codes over such degraded wireless channels using different code rates for the inner convolution code is presented.

A paper by MA, H.H. Et Al. "On tail biting convolutional codes" relates to a generalized tail biting encoding to ameliorate the rate deficiency. The tail biting encoding provides an important link between quasi-cyclic block and convolutional codes. Optimum and suboptimum decoding algorithms for the codes are discussed. The performance of the codes is determined using analytical and simulation techniques.

A paper by Mao, Yinyou Et Al. "A serially concatenated coding scheme of polar code and the improved belief propagation decoding algorithm" relates to a serially concatenated scheme of polar codes with convolutional codes to improve the error correction performance. The belief propagation decoding algorithm addresses two issues present in the currently available belief propagation decoding algorithms. The first issue is the poor performance of the belief propagation decoding algorithms, particularly the introduction of an error floor. The second is the component codes that only use systematic codes in the traditional concatenated scheme of polar codes with convolutional codes. The novel belief propagation decoding algorithm is based on right-directed message processing to improve the decoding performance effectively. This inhibits the effective update of the prior information of the redundant check bits. In addition, the novel concatenated scheme extends the selection of component codes from the systematic polar codes to the non-systematic polar codes. Hence, the areas of applications and the prior information of information bits for polar codes are expanded and more effectively updated. The simulation results show that the novel scheme is much better than the traditional concatenated scheme regarding block error rate, storage and computational complexities.

## SUMMARY

The object of the present invention is to provide an encoding method and apparatus, to improve decoding performance. This object is solved by the attached independent claims, and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the claimed invention or its embodiments.

According to a first aspect of the invention, the invention provides an encoding method, including: obtaining a to-be-encoded bit sequence; performing polar encoding on the to-be-encoded bit sequence to obtain a first bit sequence; performing convolutional encoding on the first bit sequence to obtain a second bit sequence; and outputting the second bit sequence.

In the foregoing process, polar encoding is first performed on the to-be-encoded bit sequence to obtain the first bit sequence, and then convolutional encoding is performed on the first bit sequence to obtain the second bit sequence. Because convolutional encoding is cascaded after polar encoding, an encoding process of the to-be-encoded bit sequence is more adequate, and decoding performance can be improved.

According to the invention, the convolutional encoding is implemented by using a feedforward shift register. The feedforward shift register includes m registers and k taps, initial bits in the m registers are last m bits in the first bit sequence, and k is an odd number.

In the foregoing process, the feedforward shift register meets the following two conditions: A quantity k of taps is an odd number; and the initial bits in the m registers are the last m bits in the first bit sequence, so that it can be ensured that an encoding result can be successfully decoded by a receiving device.

In a possible implementation, each bit in the second bit sequence is obtained by performing a modulo-2 summation operation on bits extracted by the k taps.

In a possible implementation, a length of the first bit sequence is n, and n>m; and the performing convolutional encoding on the first bit sequence to obtain a second bit sequence includes: initializing the last m bits in the first bit sequence to the m registers, and performing the modulo-2 summation operation on the bits extracted by the k taps, to obtain an output bit $x_0$; and performing an $i^{th}$ time of shift update on bits in the m registers based on a bit order in the first bit sequence, and performing the modulo-2 summation operation on the bits extracted by the k taps and obtained after the $i^{th}$ time of shift update, to obtain an output bit $x_i$ corresponding to the $i^{th}$ time of shift update, where i is successively 1, 2, ..., and n-1, and the second bit sequence is $X = \{x_0, x_1, x_2, ... , x_{n-1}\}$.

In a possible but not claimed implementation, the performing an $i^{th}$ time of shift update on bits in the m registers based on a bit sequence in the first bit sequence includes: shifting bits in the m registers by one bit to the right.

In the foregoing not-claimed process, a process of performing initialization and shift update on the feedforward shift register, so that the conventional encoding can be accurately performed on the first bit sequence to obtain the second bit sequence. In this way, an encoding effect is improved, and decoding performance is improved.

In a possible implementation, m is a positive integer greater than or equal to 5.

m is set to a positive integer greater than or equal to 5, so that an encoding effect on the first bit sequence can be improved, and decoding performance can be improved.

In a possible implementation, the convolutional encoding is tail-biting convolutional encoding, and in a polynomial corresponding to the tail-biting convolutional encoding, a quantity of coefficients 1 is an odd number.

Because the tail-biting convolutional encoding uses last bits of the to-be-encoded bit sequence as an initial state of the register, each time of encoding starts and ends in a same state. In this way, encoding efficiency can be improved.

According to the invention, a length of the second bit sequence is the same as the length of the first bit sequence.

According to a second aspect of the invention, the invention provides an encoding apparatus, including an obtaining module, a first encoding module, a second encoding module, and an output module.

The obtaining module is configured to obtain a to-be-encoded bit sequence. The first encoding module is configured to perform polar encoding on the to-be-encoded bit sequence to obtain a first bit sequence. The second encoding module is configured to perform convolutional encoding on the first bit sequence to obtain a second bit sequence. The output module is configured to output the second bit sequence.

According to the invention, the convolutional encoding is implemented by using a feedforward shift register. The feedforward shift register includes m registers and k taps, initial bits in the m registers are last m bits in the first bit sequence, and k is an odd number.

In a possible implementation, each bit in the second bit sequence is obtained by performing a modulo-2 summation operation on bits extracted by the k taps.

In a possible implementation, a length of the first bit sequence is n, and n>m; and the second encoding module is specifically configured to: initialize the last m bits in the first bit sequence to the m registers, and perform the modulo-2 summation operation on the bits extracted by the k taps, to obtain an output bit $x_0$; and perform an $i^{th}$ time of shift update on bits in the m registers based on a bit order in the first bit sequence, and perform the modulo-2 summation operation on the bits extracted by the k taps and obtained after the $i^{th}$ time of shift update, to obtain an output bit $x_i$ corresponding to the $i^{th}$ time of shift update, where i is successively 1, 2, ..., and n-1, and the second bit sequence is $x = \{x_0, x_1, x_2, ... ,x_{n-1}\}$.

In a possible not-claimed implementation, the second encoding module is specifically configured to shift bits in the m registers by one bit to the right.

In a possible not-claimed implementation, m is a positive integer greater than or equal to 5.

In a possible not-claimed implementation, the convolutional encoding is tail-biting convolutional encoding, and in a polynomial corresponding to the tail-biting convolutional encoding, a quantity of coefficients 1 is an odd number.

According to the invention, a length of the second bit sequence is the same as the length of the first bit sequence.

According to a third not-claimed aspect, an embodiment of this application provides an encoding apparatus, including a memory and a processor. The memory is configured to store a computer program, and the processor runs the computer program to perform the encoding method according to any implementation of the first aspect.

In a possible not-claimed implementation, the memory and the processor are integrated.

According to a fourth not-claimed aspect, an embodiment of this application provides an encoding apparatus, including an input interface, a logic circuit, and an output interface.

The input interface is configured to obtain a to-be-encoded bit sequence.

The logic circuit is configured to: perform polar encoding on the to-be-encoded bit sequence to obtain a first bit sequence, and perform convolutional encoding on the first bit sequence to obtain a second bit sequence.

The output interface is configured to output the second bit sequence.

In some possible not-claimed implementations, the logic circuit is further configured to perform the encoding method in any feasible implementation of the first aspect.

According to a fifth aspect of the invention, the invention provides a storage medium, the storage medium includes a computer program, and the computer program is used to implement the encoding method according to any implementation of the first aspect.

According to a sixth aspect of the invention, the invention provides a computer program product, the computer program product includes a computer program, and when the computer program is executed by a processor, the method in any implementation of the first aspect is implemented.

Embodiments of this present invention provide an encoding method and apparatus, and the method includes: obtaining a to-be-encoded bit sequence; first performing polar encoding on the to-be-encoded bit sequence to obtain a first bit sequence; and then performing convolutional encoding on the first bit sequence to obtain a second bit sequence, and outputting the second bit sequence. In the foregoing process, because the convolutional encoding is cascaded after the polar encoding, an encoding process of the to-be-encoded bit sequence is more adequate, and decoding performance can be improved.

In the following description, features which in the above summary of the invention have been marked as "not claimed" or "according to the invention" are also hereinafter, when they are described and explained with reference to the drawings, to be understood as "not claimed" or "not part of the invention" or "according to the invention".

## BRIEF DESCRIPTION OF DRAWINGS

FIG. 1 is a schematic diagram of an architecture of a communication system according to an embodiment of this application;

FIG. 2 is a schematic flowchart of information transmission according to an embodiment of this application;

FIG. 3 is a schematic diagram of an encoding process of polar code according to an embodiment of this application;

FIG. 4 is a schematic flowchart of an encoding method according to an embodiment of this application;

FIG. 5 is a schematic diagram of a cascaded encoding process according to an embodiment of this application;

FIG. 6 is a schematic diagram of a feedforward shift register according to an embodiment of this application;

FIG. 7A to FIG. 7H are schematic diagrams of a process of performing convolutional encoding by using a feedforward shift register according to an embodiment of this application;

FIG. 8 is a schematic diagram of another feedforward shift register according to an embodiment of this application;

FIG. 9 is a schematic diagram of another cascaded encoding process according to an embodiment of this application;

FIG. 10 is a schematic diagram of another cascaded encoding process according to an embodiment of this application;

FIG. 11 is a schematic diagram of a simulation effect of decoding performance according to an embodiment of this application;

FIG. 12 is a schematic diagram of a structure of an encoding apparatus according to an embodiment of this application;

FIG. 13 is a schematic diagram of a structure of another encoding apparatus according to an embodiment of this application; and

FIG. 14 is a schematic diagram of a structure of still another encoding apparatus according to an embodiment of this application.

## DESCRIPTION OF EMBODIMENTS

A network architecture and a service scenario described in embodiments of this application are intended to describe technical solutions in embodiments of this application, and do not constitute a limitation on the technical solutions provided in embodiments of this application. A person of ordinary skill in the art may learn that, with evolution of a network architecture and emergence of a new service scenario, the technical solutions provided in embodiments of this application are also applicable to a similar technical problem.

Embodiments of this application may be applied to a wireless communication system. It should be noted that the wireless communication system mentioned in embodiments of this application includes but is not limited to a global system for mobile communications (global system of mobile communications, GSM for short) system, a code division multiple access (code division multiple access, CDMA) system, a wideband code division multiple access (wideband code division multiple access, WCDMA) system, a general packet radio service (general packet radio service, GPRS), a long term evolution (long term evolution, LTE) system, a long term evolution advanced LTE-A (LTE advanced) system, an LTE frequency division duplex (frequency division duplex, FDD) system, an LTE time division duplex (time division duplex, TDD) system, a universal mobile telecommunications system (universal mobile telecommunication system, UMTS for short), a fifth generation mobile communication technology (5th generation mobile networks, 5G for short) communication system, a new radio (new radio, NR) communication system, a future sixth generation mobile communication technology (6th generation mobile networks, 6G for short) communication system, a Bluetooth system, a Wi-Fi system, a satellite communication system, a device-to-device (device-to-device, D2D) communication system, a machine communication system, an internet of vehicles network, or even a more advanced communication system.

A communication apparatus in this application mainly includes a network device or a terminal device. If a sending device in this application may be a network device, a receiving device is a terminal device. If the sending device in this application is a terminal device, the receiving device is a network device.

In embodiments of this application, the terminal device (terminal device) includes but is not limited to a mobile station (mobile station, MS), a mobile terminal (mobile terminal), a mobile telephone (mobile telephone), a handset (handset), portable equipment (portable equipment), and the like. The terminal device may communicate with one or more core networks by using a radio access network (radio access network, RAN). For example, the terminal device may be a mobile phone (or referred to as a "cellular" phone) or a computer with a wireless communication function, or the terminal device may be a computer with a wireless receiving/transmitting function, a virtual reality (virtual reality, VR) terminal device, an augmented reality (augmented reality, AR) terminal device, a wireless terminal in industrial control (industrial control), a wireless terminal in self driving (self driving), a remote terminal in remote medical (remote medical), a wireless terminal in a smart grid (smart grid), a wireless terminal in transportation safety (transportation safety), a wireless terminal in a smart city (smart city), a wireless terminal in a smart home (smart home), or the like. In different networks, a terminal may be referred to as different names, for example, user equipment, a mobile station, a subscriber unit, a station, a cellular phone, a personal digital assistant, a wireless modem, a wireless communication device, a handheld device, a laptop computer, a cordless phone, and a wireless local loop station. For ease of description, the terminal is referred to as a terminal device for short in this application.

In embodiments of this application, a network device may be a device used to communicate with the terminal device. For example, the network device may be a base transceiver station (base transceiver station, BTS) in a GSM system or a CDMA system, or may be a NodeB (nodeB, NB) in a WCDMA system, or may be an evolved NodeB (evolved nodeB, eNB or eNodeB) in an LTE system, or a transmission reception point (transmission reception point, TRP) or a next-generation NodeB (generation nodeB, gNB) in a new radio (new radio, NR) network, or the network device may be a satellite, a relay station, an access point, a vehicle-mounted device, a wearable device, a network side device in a 5G network, a base station, or a future evolved public land mobile network (public land mobile network, PLMN), or a network device in a network which a plurality of other technologies are fused. It should be noted that, when the solution in embodiments of this application is applied to another system that may occur in the future, names of the base station and the terminal may change, but this does not affect implementation of the solution in embodiments of this application.

Embodiments of this application relate to a channel encoding/decoding technology used to improve information transmission reliability and ensure communication quality in a communication scenario, and may be applied to a scenario in which information is encoded and decoded, for example, may be applied to a scenario in which enhanced mobile broadband (enhanced mobile broad band, eMBB) uplink control information and downlink control information are encoded and decoded, or may be applied to another scenario, for example, channel encoding (channel encoding), uplink control information, downlink control information, and a channel encoding part of a sidelink channel that are applied to 5.1.3 of the communication standard TS 36.212. This is not limited in embodiments of this application.

Embodiments of this application are not only applicable to wireless communication, but are also applicable to some application scenarios such as wired communication and data storage in which encoding and decoding need to be performed. For a scenario to which embodiments of this application are applicable, details are not described herein in embodiments.

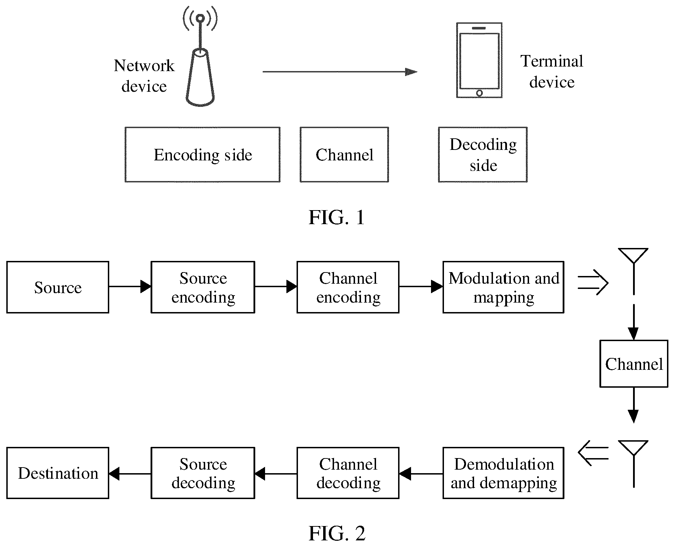

FIG. 1 is a schematic diagram of an architecture of a communication system according to an embodiment of this application. As shown in FIG. 1, the communication system in this application may include a sending device and a receiving device.

Optionally, when the sending device is a terminal device, the receiving device is a network device; and when the sending device is a network device, the receiving device is a terminal device.

The sending device may also be referred to as an encoding end. The sending device includes an encoder, and the sending device may perform encoding by using the encoder, and transmit an encoded sequence to the receiving device by using a channel.

The receiving device may also be referred to as a decoding end. The receiving device includes a decoder, and the receiving device may decode a received sequence by using the decoder.

It should be noted that FIG. 1 merely shows an architecture diagram of a communication system in a form of an example, and does not limit the architecture diagram of the communication system.

FIG. 2 is a schematic flowchart of information transmission according to an embodiment of this application. As shown in FIG. 2, in an information transmission process, the sending device performs source encoding and channel encoding on to-be-sent information (which may also be referred to as an information bit sequence, a to-be-encoded bit sequence, or a source), to obtain an encoded bit sequence. An encoded bit is transmitted on the channel to the receiving device after digital modulation. The receiving device performs digital demodulation on a received sequence to obtain a to-be-decoded bit sequence (that is, the foregoing encoded bit sequence). Then, the receiving device performs channel decoding and source decoding on the to-be-decoded bit sequence to obtain decoded information (which may also be referred to as a decoded bit sequence or a destination). Channel encoding (forward error correction, FEC)/decoding is one of key technologies of the communication system, and plays a vital role in information transmission reliability, system sensitivity, an anti-interference capability, and the like.

Currently, an encoding manner used in a 5G mobile communication system is mainly a polar (polar) encoding manner. Polar code is the first good code that can theoretically reach a Shannon capacity and has low encoding/decoding complexity. Therefore, the polar code has a good development and application prospect.

An encoding process of the polar code is $x = u \cdot F_n$, where u is a binary vector whose length is n, and $F_n$ is a Kronecker (Kronecker) transformation matrix, and is also a generation matrix G of the polar code. $F_n = \begin{bmatrix} 1 & 0 \\ 1 & 1 \end{bmatrix}^{\otimes n}$ is a

Kronecker product of n matrices $\begin{bmatrix} 1 & 0 \\ 1 & 1 \end{bmatrix}$. A polarization phenomenon occurs on code generated by using the method, and decoding may be performed by using a successive cancellation (successive cancellation, SC) decoding method. By using a polarization phenomenon, some bits in u pass through an equivalent high-reliability channel and are decoded at a high probability, and remaining bits pass through an equivalent low-reliability channel and are decoded at a low probability. Correspondingly, the high-reliability channel is used for information transmission, and a bit corresponding to the low-reliability channel is set to zero (frozen), and no data is transmitted.

In an encoding process of the polar code, a part of bits in *u* are used to carry information, and are referred to as information bits, and an index set of these bits is denoted as A. The other part of bits are set to fixed values agreed on in advance by a receive end and a transmit end, and are referred to as frozen bits (fixed bits), and a set of indexes of these bits is represented by a complementary set $A^c$ of A. Generally, these frozen bits are set to 0. However, it should be understood that the frozen bit may be arbitrarily set provided that the frozen bit is agreed on in advanced by the receive end and the transmit end.

The polar code is decoded based on a successive cancellation (successive cancellation, SC) decoding algorithm, a serial cancellation list (SC list, SCL) decoding algorithm, or the like. The SC decoding algorithm means that sequential decoding is performed from a first bit. The successive cancellation list (successive cancellation list, SCL) decoding algorithm is an improvement on the SC decoding algorithm. A plurality of candidate decoding paths are reserved for each bit, and after all bits are decoded, all candidate decoding paths in a list are selected according to a specific criterion, to obtain a final decoding result.

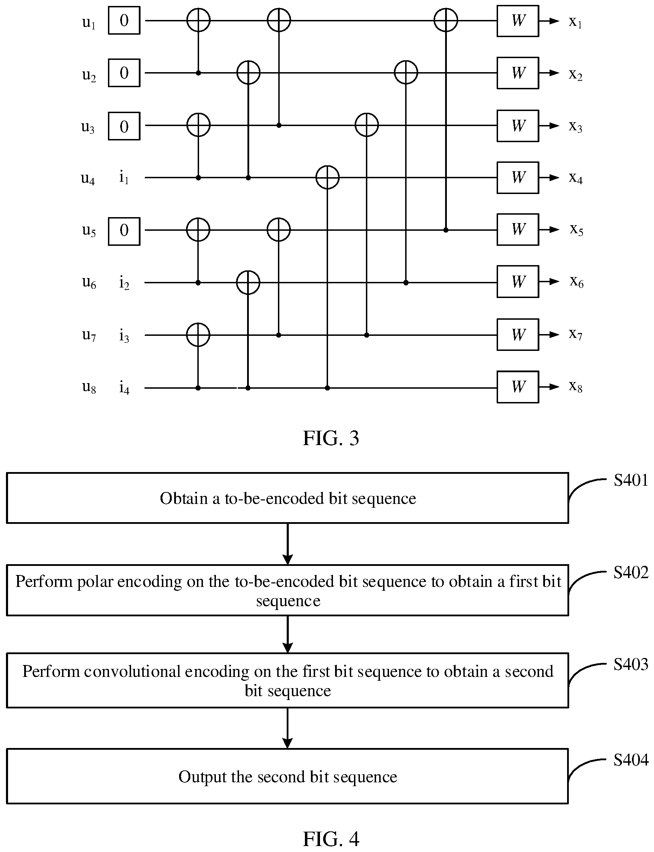

FIG. 3 is a schematic diagram of an encoding process of polar code according to an embodiment of this application. As shown in FIG. 3, $\{u_1, u_2, u_3, u_5\}$ is set to frozen bits, and $\{u_4, u_6, u_7, u_8\}$ is set to information bits. Four information bits in an information vector with a length of 4 are encoded into encoded bits $\{x_1, x_2, x_3, x_4, x_5, x_6, x_7, x_8\}$ with a length of 8. For example, all frozen bits in FIG. 3 are set to 0. A symbol with a cross in a circle represents modulo-2 addition. After the foregoing encoding, the encoded bits are modulated and then transmitted from a noise channel.

However, decoding performance of the foregoing polar encoding method needs to be improved. Therefore, an embodiment of this application provides a cascaded encoding method in which polar encoding and convolutional encoding are cascaded. First, polar encoding is performed on to-be-encoded information bit to obtain a first bit sequence, and then convolutional encoding is performed on the first bit sequence to obtain a second bit sequence, and the second bit sequence is output as an encoding result, so that decoding performance is improved.

Specific embodiments are used below to describe in detail the technical solutions of this application. The following several specific embodiments may be combined with each other, and a same or similar concept or process may not be described repeatedly in some embodiments.

FIG. 4 is a schematic flowchart of an encoding method according to an embodiment of this application. The method in this embodiment is performed by a sending device (an encoding end). As shown in FIG. 4, the method in this embodiment may include the following steps.

S401: Obtain a to-be-encoded bit sequence.

The to-be-encoded bit sequence may be a sequence of information bits to be sent by the sending device. The information bit is a bit used to carry information.

S402: Perform polar encoding on the to-be-encoded bit sequence to obtain a first bit sequence.

A process in which the sending device performs polar (Polar) encoding on the to-be-encoded bit sequence may be an existing polar encoding method, and details are not described herein.

For example, the sending device uses the to-be-encoded bit sequence as the information bits, performs polar encoding on the information bit and a frozen bit, and obtains the first bit sequence after encoding. In this embodiment, an encoding construction manner used for encoding the information bit and the frozen bit is not particularly limited.

It should be understood that the first bit sequence is a binary bit sequence. In other words, a value of each bit in the first bit sequence is 0 or 1.

S403: Perform convolutional encoding on the first bit sequence to obtain a second bit sequence.

S404: Output the second bit sequence.

The first bit sequence is a bit sequence obtained after polar encoding is performed on the to-be-encoded bit sequence. In this embodiment, after the first bit sequence is obtained, convolutional encoding is performed on the first bit sequence to obtain the second bit sequence, and the second bit sequence is output as a final encoding result.

In this embodiment, the convolutional encoding is cascaded after the polar encoding to obtain the encoding result, so that encoding of the to-be-encoded bit sequence is more adequate, and therefore decoding performance can be improved.

In a possible implementation, the convolutional encoding in S403 may be implemented by using a feedforward shift register.

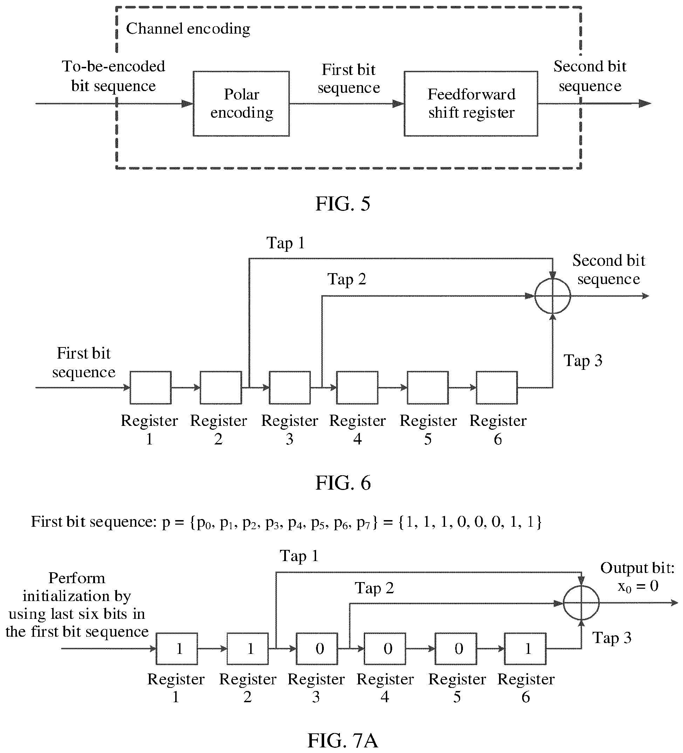

In other words, when performing channel encoding, the sending device may be cascaded to the feedforward shift register after the polar encoding. FIG. 5 is a schematic diagram of a cascaded encoding process according to an embodiment of this application. As shown in FIG. 5, polar encoding is performed on a to-be-encoded bit sequence to obtain a first bit sequence. Convolutional encoding is performed on the first bit sequence by using the feedforward shift register to obtain a second bit sequence, and the second bit sequence is used as an encoding result.

The feedforward shift register includes m registers and k taps. FIG. 6 is a schematic diagram of a feedforward shift register according to an embodiment of this application. For example, in FIG. 6, it is assumed that the feedforward shift register includes six registers and three taps, that is, m=6 and k=3.

With reference to FIG. 6, bits in the first bit sequence are shifted to the feedforward shift register to update bits in the register. A tap 1 is used to extract a bit in a register 2, a tap 2 is used to extract a bit in a register 3, and a tap 3 is used to extract a bit in a register 6. A modulo-2 summation operation is performed on the bits extracted by the foregoing three taps, and an obtained operation result is one bit in the second bit sequence.

It should be understood that the second bit sequence is a binary bit sequence. In other words, a value of each bit in the second bit sequence is 0 or 1.

Optionally, a length of the second bit sequence is the same as a length of the first bit sequence. In other words, it is assumed that the first bit sequence includes n bits, and the second bit sequence obtained after the convolutional encoding is performed on the first bit sequence by using the feedforward shift register also includes n bits.

In this embodiment, to ensure that the encoding result can be successfully decoded by a receiving device, the feedforward shift register needs to meet the following conditions:

Condition 1: A quantity k of taps is an odd number.
Condition 2: Initial bits in the m registers are last m bits in the first bit sequence.

A process of performing convolutional encoding on the first bit sequence by using the feedforward shift register is first described below, and then the foregoing two conditions that need to be met by the feedforward shift register are explained.

In a possible implementation, the convolutional encoding may be performed on the first bit sequence in the following manner to obtain the second bit sequence:

initializing the last m bits in the first bit sequence to the m registers, and performing a modulo-2 summation operation on bits extracted by the k taps, to obtain an output bit $x_0$; and
performing an $i^{th}$ time of shift update on bits in the m registers based on a bit order in the first bit sequence, and performing the modulo-2 summation operation on the bits extracted by the k taps and obtained after the $i^{th}$ time of shift update, to obtain an output bit $x_i$ corresponding to the $i^{th}$ time of shift update, where i is successively 1, 2, ..., and n-1.

Optionally, when the $i^{th}$ time of shift update is performed, the bits in the m registers are sequentially shifted by one bit to the right. To be specific, a bit in a leftmost register is a bit newly shifted from the first bit sequence, bits in remaining registers are sequentially shifted by one bit to the right, and a bit in a rightmost register is shifted out.

An output bit sequence $x = \{x_0, x_1, x_2, ... , x_{n-1}\}$ obtained after the foregoing initialization and shift update processes is the second bit sequence. In other words, each bit in the second bit sequence is obtained by performing the modulo-2 summation operation on the bits extracted by the k taps.

A process of performing convolutional encoding on the first bit sequence is described as an example below with reference to FIG. 7A to FIG. 7H.

FIG. 7A to FIG. 7H are schematic diagrams of a process of performing convolutional encoding by using a feedforward shift register according to an embodiment of this application. It is assumed that the first bit sequence is p = {p_0, p_1, p_2, p_3, p_4, p_5, p_6, p_7} = {1,1,1,0,0,0,1,1}, and the process of performing convolutional encoding on the first bit sequence is described as an example by using the feedforward shift register shown in FIG. 6 as an example.

(1) Last six bits {p_2, p_3, p_4, p_5, p_6, p_7} in the first bit sequence are used to initialize the six registers. The six registers are successively initialized in a back-to-front order of the six bits. To be specific, $p_7$ is used to initialize a register 1, $p_6$ is used to initialize the register 2, $p_5$ is used to initialize the register 3, $p_4$ is used to initialize a register 4, $p_3$ is used to initialize a register 5, and $p_2$ is used to initialize the register 6.

For example, as shown in FIG. 7A, after the six registers are successively initialized in the back-to-front order of the six bits, a bit in the register 1 is 1, a bit in the register 2 is 1, a bit in the register 3 is 0, a bit in the register 4 is 0, a bit in the register 5 is 0, and a bit in the register 6 is 1. In this initial state, the tap 1 extracts the bit 1 in the register 2, the tap 2 extracts the bit 0 in the register 3, and the tap 3 extracts the bit 1 in the register 6, and the modulo 2 summation operation is performed on the bits extracted by the foregoing three taps. An obtained output bit is $x_0 = 0$.

A process of initializing the six registers is described in the foregoing step (1). A process of performing shift update on the six registers in a bit order in the first bit sequence is described in the following steps (2) to (8).

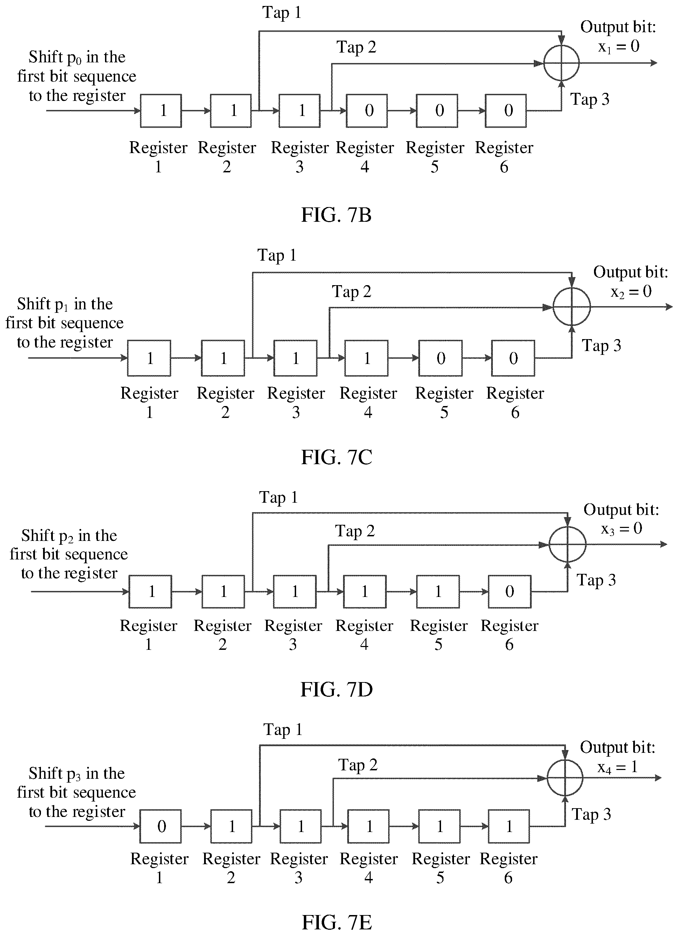

(2) A first time of shift update is performed on the bits in the six registers. As shown in FIG. 7B, $p_0$ in the first bit sequence is shifted to the register 1, and bits in remaining registers are sequentially shifted by one bit to the right. In this case, the bit in the register 6 is shifted out.

After the first time of shift update, the bit in the register 1 is 1, the bit in the register 2 is 1, the bit in the register 3 is 1, the bit in the register 4 is 0, the bit in the register 5 is 0, and the bit in the register 6 is 0. In a state obtained after the shift update, the tap 1 extracts the bit 1 in the register 2, the tap 2 extracts the bit 1 in the register 3, and the tap 3 extracts the bit 0 in the register 6, and the modulo 2 summation operation is performed on the bits extracted by the foregoing three taps. An obtained output bit is $x_1 = 0$.

(3) A second time of shift update is performed on the bits in the six registers. As shown in FIG. 7C, $p_1$ in the first bit sequence is shifted to the register 1, and bits in remaining registers are sequentially shifted by one bit to the right. In this case, the bit in the register 6 is shifted out.

After the second time of shift update, the bit in the register 1 is 1, the bit in the register 2 is 1, the bit in the register 3 is 1, the bit in the register 4 is 1, the bit in the register 5 is 0, and the bit in the register 6 is 0. In a state obtained after the shift update, the tap 1 extracts the bit 1 in the register 2, the tap 2 extracts the bit 1 in the register 3, and the tap 3 extracts the bit 0 in the register 6, and the modulo 2 summation operation is performed on the bits extracted by the foregoing three taps. An obtained output bit is $x_2 = 0$.

(4) A third time of shift update is performed on the bits in the six registers. As shown in FIG. 7D, $p_2$ in the first bit sequence is shifted to the register 1, and bits in remaining registers are sequentially shifted by one bit to the right. In this case, the bit in the register 6 is shifted out.

After the third time of shift update, the bit in the register 1 is 1, the bit in the register 2 is 1, the bit in the register 3 is 1, the bit in the register 4 is 1, the bit in the register 5 is 1, and the bit in the register 6 is 0. In a state obtained after the shift update, the tap 1 extracts the bit 1 in the register 2, the tap 2 extracts the bit 1 in the register 3, and the tap 3 extracts the bit 0 in the register 6, and the modulo 2 summation operation is performed on the bits extracted by the foregoing three taps. An obtained output bit is $x_3 = 0$.

(5) A fourth time of shift update is performed on the bits in the six registers. As shown in FIG. 7E, $p_3$ in the first bit sequence is shifted to the register 1, and bits in remaining registers are sequentially shifted by one bit to the right. In this case, the bit in the register 6 is shifted out.

After the fourth time of shift update, the bit in the register 1 is 0, the bit in the register 2 is 1, the bit in the register 3 is 1, the bit in the register 4 is 1, the bit in the register 5 is 1, and the bit in the register 6 is 1. In a state obtained after the shift update, the tap 1 extracts the bit 1 in the register 2, the tap 2 extracts the bit 1 in the register 3, and the tap 3 extracts the bit 1 in the register 6, and the modulo 2 summation operation is performed on the bits extracted by the foregoing three taps. An obtained output bit is $x_4 = 1$.

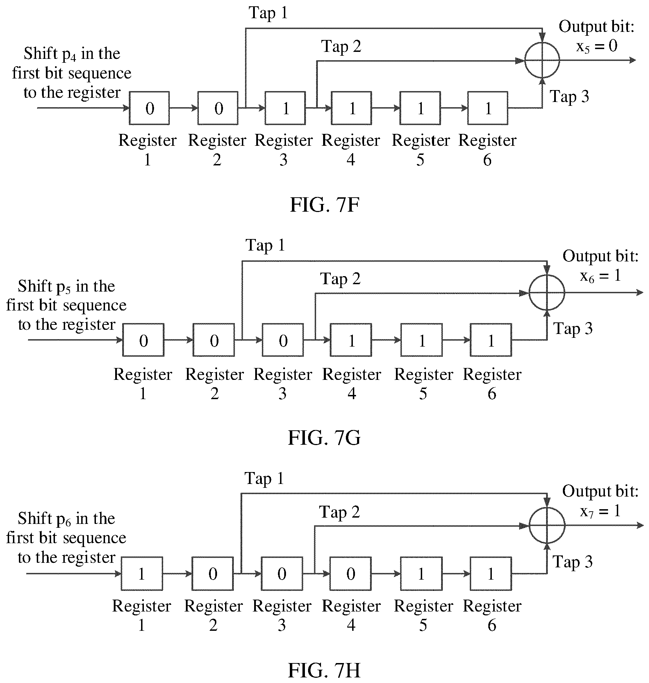

(6) A fifth time of shift update is performed on the bits in the six registers. As shown in FIG. 7F, $p_4$ in the first bit sequence is shifted to the register 1, and bits in remaining registers are sequentially shifted by one bit to the right. In this case, the bit in the register 6 is shifted out.

After the fifth time of shift update, the bit in the register 1 is 0, the bit in the register 2 is 0, the bit in the register 3 is 1, the bit in the register 4 is 1, the bit in the register 5 is 1, and the bit in the register 6 is 1. In a state obtained after the shift update, the tap 1 extracts the bit 0 in the register 2, the tap 2 extracts the bit 1 in the register 3, and the tap 3 extracts the bit 1 in the register 6, and the modulo 2 summation operation is performed on the bits extracted by the foregoing three taps. An obtained output bit is $x_5 = 0$.

(7) A sixth time of shift update is performed on the bits in the six registers. As shown in FIG. 7G, $p_5$ in the first bit sequence is shifted to the register 1, and bits in remaining registers are sequentially shifted by one bit to the right. In this case, the bit in the register 6 is shifted out.

After the sixth time of shift update, the bit in the register 1 is 0, the bit in the register 2 is 0, the bit in the register 3 is 0, the bit in the register 4 is 1, the bit in the register 5 is 1, and the bit in the register 6 is 1. In a state obtained after the shift update, the tap 1 extracts the bit 0 in the register 2, the tap 2 extracts the bit 0 in the register 3, and the tap 3 extracts the bit 1 in the register 6, and the modulo 2 summation operation is performed on the bits extracted by the foregoing three taps. An obtained output bit is $x_6 = 1$.

(8) A seventh time of shift update is performed on the bits in the six registers. As shown in FIG. 7H, $p_6$ in the first bit sequence is shifted to the register 1, and bits in remaining registers are sequentially shifted by one bit to the right. In this case, the bit in the register 6 is shifted out.

After the seventh time of shift update, the bit in the register 1 is 1, the bit in the register 2 is 0, the bit in the register 3 is 0, the bit in the register 4 is 0, the bit in the register 5 is 1, and the bit in the register 6 is 1. In a state obtained after the shift update, the tap 1 extracts the bit 0 in the register 2, the tap 2 extracts the bit 0 in the register 3, and the tap 3 extracts the bit 1 in the register 6, and the modulo 2 summation operation is performed on the bits extracted by the foregoing three taps. An obtained output bit is $x_7 = 1$.

A sequence of the output bits obtained in the foregoing steps (1) to (8) are the second bit sequence, that is, the second bit sequence $x = \{x_0, x_1, x_2, \ldots, x_{n-1}\} = \{0,0,0,0,1,0,1,1\}$.

It may be learned from the encoding process shown in FIG. 7A to FIG. 7H that when convolutional encoding is performed on the first bit sequence $p = \{p_0, p_1, p_2, p_3, p_4, p_5, p_6, p_7\} = \{1,1,1,0,0,0,1,1\}$ by using the shift register, an obtained encoding result is the second bit sequence $x = \{x_0, x_1, x_2, \ldots, x_{n-1}\} = \{0,0,0,0,1,0,1,1\}$.

In this embodiment, when the convolutional encoding in S403 is implemented by using the feedforward shift register, a structure of the shift register may be determined based on a generator polynomial of the convolutional encoding, or the shift register may be represented by the generator polynomial of the convolutional encoding.

The generator polynomial of the convolutional encoding may be in a binary representation form, or may be in an octal representation form, a decimal representation form, or a hexadecimal representation form.

When the binary representation form is used, a quantity of registers in the feedforward shift register may be determined based on a quantity of bits in the binary representation form, and locations and a quantity of taps in the feedforward shift register may be determined based on locations and a quantity of bits 1 in the binary representation form.

The generator polynomial $G(X) = X^6 + X^4 + X^3 + X + 1$ of the convolutional encoding is used as an example. First, the generator polynomial is converted into the binary representation form. If a highest power of X in the polynomial is 6, there are seven bits in total in a binary representation, and bits from left to right are respectively coefficients corresponding to sixth, fifth, fourth, third, second, first, and zeroth power of X in the polynomial. Therefore, the binary representation form corresponding to the generator polynomial is 1011011. A hexadecimal representation form corresponding to the generator polynomial is 5B.

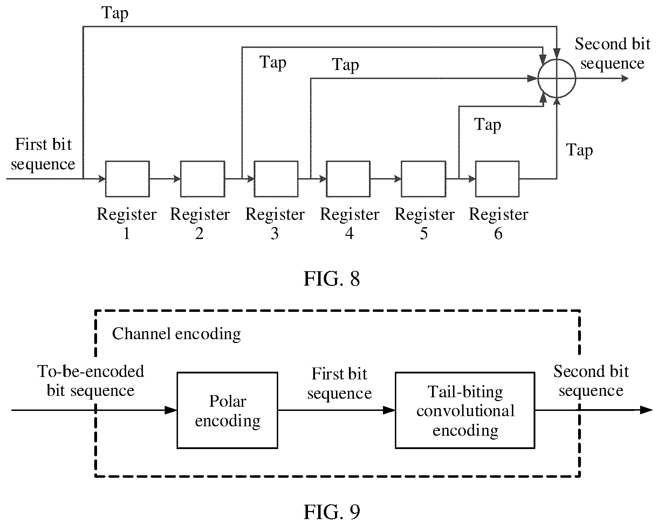

The feedforward shift register corresponding to the generator polynomial of the convolutional encoding may use a structure shown in FIG. 8. FIG. 8 is a schematic diagram of another feedforward shift register according to an embodiment of this application. A quantity of bits in the binary representation form (1011011) of the polynomial is 7, and it may be determined that the quantity of registers in the shift register is 6. As shown in FIG. 8, the shift register includes a register 1, a register 2, a register 3, a register 4, a register 5, and a register 6. In the binary representation form (1011011), first, third, fourth, sixth, and seventh bits from left to right are 1, and it may be determined that the shift register includes five taps that are separately located before the register 1, the register 3, the register 4, and the register 6 and after the register 6. Therefore, a structure that is of the shift register and that is determined based on the generator polynomial $G(X) = X^6 + X^4 + X^3 + X + 1$ of the convolutional encoding is shown in FIG. 8. Alternatively, the shift register shown in FIG. 8 may be represented by using a binary polynomial 1011011.

Similarly, the shift register shown in FIG. 6 may be represented by using a binary polynomial 0011001.

When the octal representation form, the decimal representation form, or the hexadecimal representation form is used, the foregoing representation form may be converted into a binary representation form, and the quantity of registers in the feedforward shift register and locations and a quantity of taps are determined based on the binary representation form.

Optionally, in this embodiment, shift registers represented by using the following polynomials may be used, and all the shift registers represented by using the following polynomials meet a condition that a quantity of taps is an odd number.

23, 25, 31, 37, 3B, 3D
43, 4F, 6D, 79, 57, 59, 5B, 5F, 75
12D, 16F, 199, 1C3, 1CF
847, A31, AA7, C57, C6D, CDF, D03, D41, D6F, D7B, DF5, F37, FE9
1173F, 13425, 1458F, 14CF7, 14D69, 15483, 16353, 17835, 178D1, 178EB, 19E61, 1A1FD, 1AE97, 1AF93, 1D4F3, 1D5F1, 1F687

It should be noted that the foregoing polynomials use the hexadecimal representation form. It can be understood that the foregoing polynomials may alternatively be represented by using other numeral systems. The numeral systems are not enumerated herein. In addition, the polynomials listed above are merely some possible examples, and do not constitute a limitation on the shift register in this embodiment of this application. In actual application, the sending device and the receiving device select a same shift register based on an agreement.

Optionally, after the hexadecimal representation form is converted into the binary representation form, a left-to-right bit order or a right-to-left bit order may be used as the generator polynomial of the convolutional encoding. For example, a hexadecimal representation form 23 is used as an example, and the hexadecimal representation form 23 is converted into a binary representation form 00100011. 00100011 may be used as the generator polynomial of the convolutional encoding, or 11000100 may be used as the generator polynomial of the convolutional encoding. In other words, 00100011 may be used to represent the feedforward shift register, or 11000100 may be used to represent the feedforward shift register.

Optionally, the quantity of registers in the feedforward shift register is m, and m is an integer greater than or equal to 5.

Based on the foregoing encoding process of the feedforward shift register, when the quantity m of registers is relatively large, an encoding effect for the first bit sequence can be improved, and decoding performance can be improved.

Optionally, the quantity of registers in the feedforward shift register is m, and m is a prime number greater than or equal to 5.

Decoding performance can be improved when the quantity of registers in the feedforward shift register is set to a prime number.

In a possible implementation, the convolutional encoding in S403 may be tail-biting convolutional code (tail biting CC, TBCC) encoding. Because the tail-biting convolutional encoding uses last bits of the to-be-encoded bit as an initial state of the register, each time of encoding starts and ends in a same state. In this way, encoding efficiency can be improved.

FIG. 9 is a schematic diagram of another cascaded encoding process according to an embodiment of this application. As shown in FIG. 9, polar encoding is performed on a to-be-encoded bit sequence to obtain a first bit sequence. Tail-biting convolutional encoding is performed on the first bit sequence to obtain a second bit sequence, and the second bit sequence is used as an encoding result.

Optionally, the tail-biting convolutional encoding may also be implemented by using a feedforward shift register. A quantity of registers and locations and a quantity of taps in the feedforward shift register may be determined by using a polynomial corresponding to the tail-biting convolutional encoding. For example, the polynomial is converted into a binary representation form, the quantity of registers in the feedforward shift register may be determined based on a quantity of bits in the binary representation form, and the locations and the quantity of taps in the feedforward shift register may be determined based on locations and a quantity of bits 1 in the binary representation form.

For example, it is assumed that a generator polynomial corresponding to the tail-biting convolutional encoding is $G(X) = X^6 + X^4 + X^3 + X + 1,$ the generator polynomial is converted into a binary representation form 1011011, and a structure of a shift register determined based on the binary representation form is shown in FIG. 8.

It should be understood that a process of performing tail-biting convolutional encoding on the first bit sequence by using the shift register shown in FIG. 8 is similar to that shown in FIG. 7A to FIG. 7H, and details are not described herein again.

In this embodiment, when the tail-biting convolutional encoding is used, because the tail-biting convolutional encoding limits last bits of the to-be-encoded bit as an initial state of the register, it is equivalent to meeting the foregoing condition 2. To ensure that an encoding result can be successfully decoded by a receiving device, in this embodiment, when the tail-biting convolutional encoding is used for encoding, a quantity of coefficients 1 in the polynomial corresponding to the tail-biting convolutional encoding is an odd number, or a quantity of bits 1 in a binary representation of a polynomial corresponding to the tail-biting convolutional encoding is an odd number. In this way, it is equivalent to also meeting the foregoing condition 1 of the feedforward shift register.

Therefore, in this embodiment, the tail-biting convolutional encoding is cascaded after the polar encoding, and provided that the quantity of coefficients 1 in the polynomial corresponding to the tail-biting convolutional encoding is an odd number, or the quantity of bits 1 in the binary representation of the polynomial corresponding to the tail-biting convolutional encoding is an odd number, it can be ensured that the encoding result can be successfully decoded by the receiving device.

For example, the polynomial corresponding to the tail-biting convolutional encoding is $G(X) = X^6 + X^4 + X^3 + X + 1$. Coefficients corresponding to a sixth power term, a fourth power term, a third power term, a first power term, and a zeroth power term of X in the polynomial are 1, and coefficients corresponding to a fifth power term and a second power term of X are 0. It can be learned that the quantity of coefficients 1 is 5. A binary representation of the polynomial is 1011011, and the quantity of bits 1 is 5. Therefore, in this embodiment, the tail-biting convolutional encoding corresponding to the polynomial is cascaded after the polar encoding, and the obtained encoding result may be successfully decoded by the receiving device.

In any one of the foregoing embodiments, the feedforward shift register needs to meet a condition 1 and a condition 2. The two conditions that need to be met by the feedforward shift register are explained below.

Condition 1: A quantity k of taps in the feedforward shift register is an odd number.

Based on the cascaded encoding process shown in FIG. 5, it is assumed that an encoding matrix corresponding to the polar encoding is G and an encoding matrix corresponding to the feedforward shift register is P, an encoding matrix corresponding to the entire cascaded encoding is Q=G*P.

It is assumed that a length of the first bit sequence (that is, a bit sequence obtained after the polar encoding) is 8, and the encoding matrix G of the polar encoding is shown as follows:

$$G = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

It may be learned from the foregoing encoding matrix G of the polar encoding that, because there is a row with all 1s in G, if a location corresponding to the row is selected as an information bit, and there are even-number taps in the feedforward shift register, there are even-number 1s in each column of the encoding matrix P corresponding to the feedforward shift register, so that there is a row with all 0s in the encoding matrix Q, and therefore, when a decoding end performs decoding, regardless of a signal-to-noise ratio, there is a bit that cannot be decoded. However, if there are odd-number taps in the feedforward shift register, there are odd-number 1s in each column in the encoding matrix P corresponding to the feedforward shift register, so that there is no row with all 0s in the encoding matrix Q. Therefore, each bit can be decoded when the decoding end performs decoding.

Two cases in which the quantity of taps is an even number and an odd number are separately described below as an example.

(1) The feedforward shift register includes even-number taps. For example, the quantity of taps is 4, and it is assumed that a generator polynomial of the feedforward shift register is represented by using a binary representation 101011.

If the convolutional encoding is performed on the first bit sequence by using the feedforward shift register, and initial bits in the feedforward shift register are set to last m bits in the first bit sequence, an encoding matrix $P_1$ corresponding to the feedforward shift register is as follows:

$$P_1 = \begin{bmatrix} 1 & 0 & 1 & 0 & 1 & 1 & 0 & 0 \\ 0 & 1 & 0 & 1 & 0 & 1 & 1 & 0 \\ 0 & 0 & 1 & 0 & 1 & 0 & 1 & 1 \\ 1 & 0 & 0 & 1 & 0 & 1 & 0 & 1 \\ 1 & 1 & 0 & 0 & 1 & 0 & 1 & 0 \\ 0 & 1 & 1 & 0 & 0 & 1 & 0 & 1 \\ 1 & 0 & 1 & 1 & 0 & 0 & 1 & 0 \\ 0 & 1 & 0 & 1 & 1 & 0 & 0 & 1 \end{bmatrix}$$

Therefore, an encoding matrix $Q_1$ corresponding to an entire joint encoding process is as follows:

$$Q_1 = G * P_1 = \begin{bmatrix} 1 & 0 & 1 & 0 & 1 & 1 & 0 & 0 \\ 1 & 1 & 1 & 1 & 1 & 0 & 1 & 0 \\ 1 & 0 & 0 & 0 & 0 & 1 & 1 & 1 \\ 0 & 1 & 0 & 0 & 0 & 1 & 0 & 0 \\ 0 & 1 & 1 & 0 & 0 & 1 & 1 & 0 \\ 0 & 1 & 0 & 1 & 0 & 1 & 0 & 1 \\ 1 & 1 & 1 & 1 & 1 & 1 & 1 & 1 \\ 0 & 0 & 0 & 0 & 0 & 0 & 0 & 0 \end{bmatrix}$$

In the foregoing encoding matrix $Q_1$, there are all 0s in a last row. Therefore, after an encoding result is obtained in the foregoing joint encoding process, when a decoding end performs decoding, regardless of a signal-to-noise ratio, there is a bit that cannot be decoded.

(2) The feedforward shift register includes odd-number taps. For example, the quantity of taps is 5, and it is assumed that a generator polynomial of the feedforward shift register is represented by using a binary representation 101111.

If the convolutional encoding is performed on the first bit sequence by using the feedforward shift register, and initial bits in the feedforward shift register are set to last m bits in the first bit sequence, an encoding matrix $P_2$ corresponding to the feedforward shift register is as follows:

$$P_2 = \begin{bmatrix} 1 & 0 & 1 & 1 & 1 & 1 & 0 & 0 \\ 0 & 1 & 0 & 1 & 1 & 1 & 1 & 0 \\ 0 & 0 & 1 & 0 & 1 & 1 & 1 & 1 \\ 1 & 0 & 0 & 1 & 0 & 1 & 1 & 1 \\ 1 & 1 & 0 & 0 & 1 & 0 & 1 & 1 \\ 1 & 1 & 1 & 0 & 0 & 1 & 0 & 1 \\ 1 & 1 & 1 & 1 & 0 & 0 & 1 & 0 \\ 0 & 1 & 1 & 1 & 1 & 0 & 0 & 1 \end{bmatrix}$$

Therefore, an encoding matrix $Q_2$ corresponding to an entire joint encoding process is as follows:

$$Q_2 = G * P_2 = \begin{bmatrix} 1 & 0 & 1 & 1 & 1 & 1 & 0 & 0 \\ 1 & 1 & 1 & 0 & 0 & 0 & 1 & 0 \\ 1 & 0 & 0 & 1 & 0 & 0 & 1 & 1 \\ 0 & 1 & 0 & 1 & 1 & 0 & 1 & 0 \\ 0 & 1 & 1 & 1 & 0 & 1 & 1 & 1 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

In the foregoing encoding matrix $Q_2$, there is no row with all 0s. Therefore, after an encoding result is obtained in the foregoing joint encoding process, each bit can be decoded when the decoding end performs decoding.

Condition 2: Initial bits in the m registers are last m bits in the first bit sequence.

When the decoding end performs decoding by using a classical SCL decoding algorithm, if the encoding end uses an initialization manner described in the condition 2, a current decoding information bit during SCL decoding is only related to an information bit that has been obtained through decoding previously. If an encoding end does not initialize the bits in the m registers to the last m bits in the first bit sequence, when the decoding end performs decoding, the current decoding information bit is related to an information bit that is not obtained through decoding, and consequently, decoding cannot be performed by using the SCL decoding algorithm.

Based on any one of the foregoing embodiments, the encoding method in this embodiment may further include a rate matching step.

Rate matching means processing on a to-be-transmitted bit sequence on a channel, so that a processed bit sequence can match a bearer capability of a physical channel. The rate matching step in this embodiment may be performed after S403.

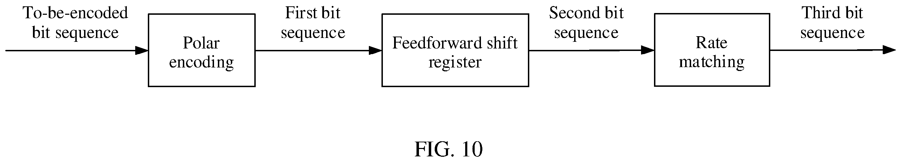

FIG. 10 is a schematic diagram of another cascaded encoding process according to an embodiment of this application. As shown in FIG. 10, a sending device performs polar encoding on a to-be-encoded bit sequence to obtain a first bit sequence. Convolutional encoding is performed on the first bit sequence by using a feedforward shift register to obtain a second bit sequence. Then, rate matching is performed on the second bit sequence to obtain a third bit sequence. The sending device outputs the third bit sequence as an encoding result. For example, the sending device modulates the third bit sequence into a channel for sending.

Optionally, the rate matching in this embodiment may be a puncturing-based or truncating-based rate matching manner.

In this embodiment, the rate matching is performed on the second bit sequence obtained by performing polar encoding and convolutional encoding on the to-be-encoded bit sequence, so that an encoding result can match a bearer capability of a physical channel.

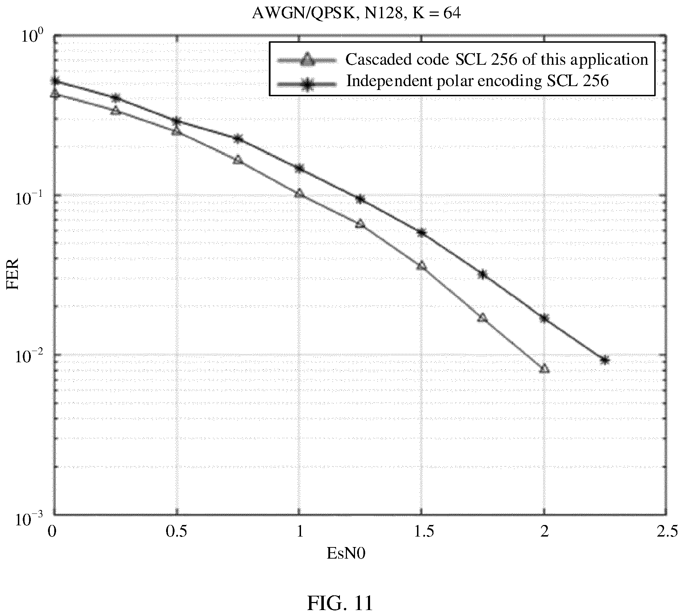

Based on any one of the foregoing embodiments, decoding performance corresponding to the cascaded encoding method in embodiments of this application is described below with reference to simulation data shown in FIG. 11.

FIG. 11 is a schematic diagram of a simulation effect of decoding performance according to an embodiment of this application. FIG. 11 shows decoding performance corresponding to a cascaded encoding manner according to an embodiment of this application, and decoding performance corresponding to a conventional separate polar encoding manner. For the foregoing two encoding manners, simulation is performed by using an SCL 256 decoding algorithm. FIG. 11 shows a result of a simulation test performed by using simulation parameters shown in Table 1.

**Table 1**

| Code length N | 128 |
|---|---|
| Information bit length K | 64 |
| Simulation channel | Additive white Gaussian noise (additive white gaussian noise, AWGN) |
| Modulation scheme | Quadrature phase shift keying (quadrature phase shift keying, QPSK) |
| Decoding algorithm | SCL 256 |

As shown in FIG. 11, a horizontal axis represents a signal-to-noise ratio, and is represented by EsN0 (that is, symbol power divided by noise power, where Es is symbol power, and N0 is the noise power). A vertical axis represents a frame error rate (Frame Error Rate, FER). In channel conditions with same EsN0, decoding FERs obtained in the cascaded encoding manner in this embodiment of this application are all less than a decoding FER obtained in a conventional separate polar encoding manner. In other words, a frame error rate in a decoding process can be significantly reduced by using the cascaded encoding manner in this embodiment of this application. When a same decoding FER is reached, a requirement on EsN0 of a channel in the cascaded encoding manner in this embodiment of this application is lower than a requirement on EsN0 of a channel in the conventional separate polar encoding manner. In other words, the requirement on EsN0 of a channel can be significantly reduced in the cascaded encoding manner in this embodiment of this application. It can be learned that the cascaded encoding manner provided in this embodiment of this application can improve decoding performance.

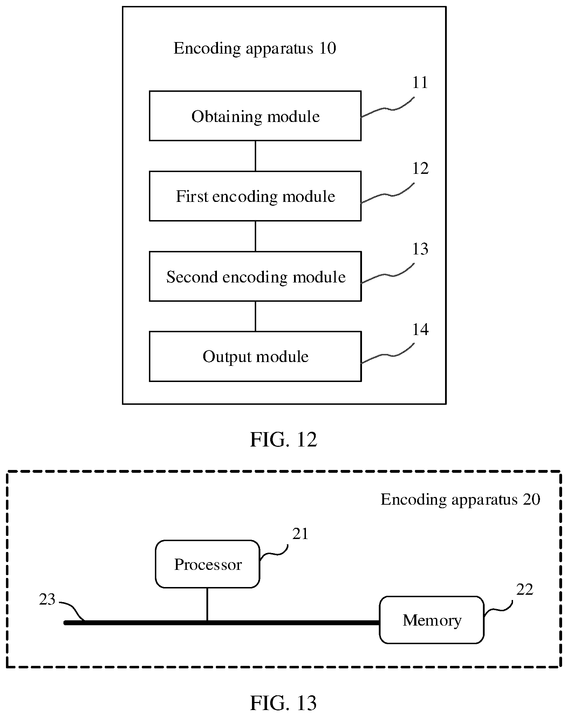

FIG. 12 is a schematic diagram of a structure of an encoding apparatus according to an embodiment of this application. As shown in FIG. 12, an encoding apparatus 10 provided in this embodiment may include an obtaining module 11, a first encoding module 12, a second encoding module 13, and an output module 14.

The obtaining module 11 is configured to obtain a to-be-encoded bit sequence. The first encoding module 12 is configured to perform polar encoding on the to-be-encoded bit sequence to obtain a first bit sequence. The second encoding module 13 is configured to perform convolutional encoding on the first bit sequence to obtain a second bit sequence. The output module 14 is configured to output the second bit sequence.

Optionally, the obtaining module 11 may perform S401 in the embodiment in FIG. 4.

Optionally, the first encoding module 12 may perform S402 in the embodiment in FIG. 4.

Optionally, the second encoding module 13 may perform S403 in the embodiment in FIG. 4.

Optionally, the output module 14 may perform S404 in the embodiment in FIG. 4.

The encoding apparatus 10 provided in this embodiment of this application may execute the technical solutions shown in the foregoing method embodiments. Implementation principles and beneficial effects of the encoding apparatus 10 are similar to those in the foregoing method embodiments, and details are not described herein again.

In a possible implementation, the convolutional encoding is implemented by using a feedforward shift register. The feedforward shift register includes m registers and k taps, initial bits in the m registers are last m bits in the first bit sequence, and k is an odd number.

In a possible implementation, each bit in the second bit sequence is obtained by performing a modulo-2 summation operation on bits extracted by the k taps.

In a possible implementation, a length of the first bit sequence is n, and n>m; and the second encoding module 13 is specifically configured to: initialize the last m bits in the first bit sequence to the m registers, and perform the modulo-2 summation operation on the bits extracted by the k taps, to obtain an output bit $x_0$; and perform an $i^{th}$ time of shift update on bits in the m registers based on a bit order in the first bit sequence, and perform the modulo-2 summation operation on the bits extracted by the k taps and obtained after the $i^{th}$ time of shift update, to obtain an output bit $x_i$ corresponding to the $i^{th}$

time of shift update, where i is successively 1, 2, ..., and n-1, and the second bit sequence is $x = \{x_0, x_1, x_2, ... , x_{n-1}\}$.

In a possible implementation, the second encoding module 13 is specifically configured to shift bits in the m registers by one bit to the right.

In a possible implementation, m is a positive integer greater than or equal to 5.

In a possible implementation, the convolutional encoding is tail-biting convolutional encoding, and in a polynomial corresponding to the tail-biting convolutional encoding, a quantity of coefficients 1 is an odd number.

In a possible implementation, a length of the second bit sequence is the same as the length of the first bit sequence.

The encoding apparatus 10 provided in this embodiment of this application may execute the technical solutions shown in the foregoing method embodiments. Implementation principles and beneficial effects of the encoding apparatus 10 are similar to those in the foregoing method embodiments, and details are not described herein again.

FIG. 13 is a schematic diagram of a structure of another encoding apparatus according to an embodiment of this application. As shown in FIG. 13, an encoding apparatus 20 provided in this embodiment may include a processor 21 and a memory 22.

The memory 22 is configured to store a computer program, and is sometimes further configured to store intermediate data.

The processor 21 is configured to execute the computer program stored in the memory 22, to implement steps in the foregoing encoding method. For details, refer to related description in the foregoing method embodiments.

Optionally, the memory 22 may be independent, or may be integrated with the processor 21. In some implementations, the memory 22 may even be located outside the encoding apparatus 20.

When the memory 22 is a component independent of the processor 21, the encoding apparatus 20 may further include a bus 23, configured to connect the memory 22 and the processor 21.

Optionally, the encoding apparatus 20 may further include a receiver and a transmitter. For example, the receiver is configured to obtain a to-be-encoded bit, and the transmitter may be configured to output an encoded second bit sequence.

The encoding apparatus 20 provided in this embodiment may be a terminal device or a network device, and may be configured to perform the encoding method in the foregoing method embodiments. An implementation and a technical effect of the encoding apparatus 20 are similar to those of the encoding method, and details are not described herein again in this embodiment.

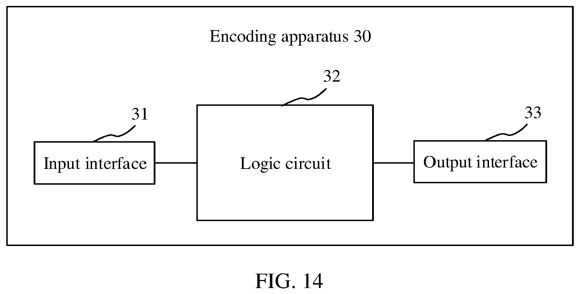

FIG. 14 is a schematic diagram of a structure of still another encoding apparatus according to an embodiment of this application. As shown in FIG. 14, an encoding apparatus 30 in this embodiment may include an input interface 31, a logic circuit 32, and an output interface 33.

The input interface 31 is configured to obtain a to-be-encoded bit sequence.

The logic circuit 32 is configured to: perform polar encoding on the to-be-encoded bit sequence to obtain a first bit sequence, and perform convolutional encoding on the first bit sequence to obtain a second bit sequence.

The output interface 33 is configured to output the second bit sequence.

Optionally, the input interface 31 may have a function of the obtaining module 11 in the embodiment in FIG. 12. The logic circuit 32 may have functions of the first encoding module 12 and the second encoding module 13 in the embodiment shown in FIG. 12. The output interface 33 may have a function of the output module 14 in the embodiment shown in FIG. 12.

Optionally, the input interface 31 may have a function of the receiver in the embodiment in FIG. 13. The logic circuit 32 may have a function of the processor 21 in the embodiment in FIG. 13. The output interface 33 may have a function of the transmitter in the embodiment shown in FIG. 13.

Optionally, the logic circuit 32 may further perform another step in the encoding method. For example, the logic circuit 32 may further perform steps described in S402 and S403 in the embodiment shown in FIG. 4.

The encoding apparatus 30 provided in this embodiment of this application may execute the technical solutions shown in the foregoing method embodiments. Implementation principles and beneficial effects of the encoding apparatus 30 are similar to those in the foregoing method embodiments, and details are not described herein again.

An embodiment of this application further provides a storage medium, the storage medium includes a computer program, and the computer program is used to implement the encoding method described in the foregoing embodiments.

An embodiment of this application further provides a chip or an integrated circuit, including a memory and a processor.

The memory is configured to store program instructions, and is sometimes further configured to store intermediate data.

The processor is configured to invoke the program instructions stored in the memory to implement the foregoing encoding method.

Optionally, the memory may be independent, or may be integrated with the processor. In some implementations, the memory may alternatively be located outside the chip or the integrated circuit.

An embodiment of this application further provides a program product. The program product includes a computer program, the computer program is stored in a storage medium, and the computer program is configured to implement the foregoing encoding method.

Methods or algorithm steps described in combination with the content disclosed in this embodiment of this application may be implemented by hardware, or may be implemented by a processor by executing software instructions. The software instructions may include a corresponding software module. The software module may be stored in a random access memory (Random Access Memory, RAM), a flash memory, a read-only memory (Read Only Memory, ROM), an erasable programmable read-only memory (Erasable Programmable ROM, EPROM), an electrically erasable programmable read-only memory (Electrically EPROM, EEPROM), a register, a hard disk, a removable hard disk, a compact disc read-only memory (CD-ROM), or any other form of storage medium well-known in the art. For example, a storage medium is coupled to a processor, so that the processor can read information from the storage medium and write information into the storage medium. Certainly, the storage medium may be a component of the processor. The processor and the storage medium may be located in an ASIC. In addition, the ASIC may be located in a base station or a terminal. Certainly, the processor and the storage medium may exist in a receiving device as discrete components.

It should be understood that the processor may be a central processing unit (English: Central Processing Unit, CPU for short), or may be another general-purpose processor, a digital signal processor (English: Digital Signal Processor, DSP for short), an application specific integrated circuit (English: Application Specific Integrated Circuit, ASIC for short), or the like. The general-purpose processor may be a microprocessor, or the processor may be any conventional processor or the like. The steps of the method disclosed with reference to embodiments of this application may be directly performed by a hardware processor, or may be performed by using a combination of hardware in the processor and a software module.

The memory may include a high-speed RAM memory, or may further include a non-volatile memory NVM, for example, at least one magnetic disk memory, or may be a USB flash drive, a removable hard disk, a read-only memory, a magnetic disk, or an optical disc.

A bus may be an industry standard architecture (Industry Standard Architecture, ISA) bus, a peripheral component interconnect (Peripheral Component, PCI) bus, an extended industry standard architecture (Extended Industry Standard Architecture, EISA) bus, or the like. The bus may include an address bus, a data bus, a control bus, and the like. For ease of representation, the bus in the accompanying drawings of this application is not limited to only one bus or one type of bus.

The foregoing storage medium may be implemented by any type of volatile or non-volatile storage device or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic disk, or an optical disc. The storage medium may be any available medium accessible to a general-purpose or special-purpose computer.

In this application, "at least one" means one or more, and "a plurality of" means two or more. "And/or" describes an association relationship for describing associated objects and represents that three relationships may exist. For example, A and/or B may represent the following cases: Only A exists, both A and B exist, and only B exists, where A and B may be singular or plural. The character "/" usually indicates an "or" relationship between associated objects. "At least one of the following items (pieces)" or a similar expression thereof refers to any combination of these items, including any combination of singular items (pieces) or plural items (pieces). For example, at least one item (piece) of a, b, and c may indicate: a, b, c, a and b, a and c, b and c, or a, b, and c, where a, b, and c may be singular or plural.

A person skilled in the art should be aware that in the foregoing one or more examples, functions described in embodiments of this application may be implemented by hardware, software, firmware, or any combination thereof. When the functions are implemented by software, the foregoing functions may be stored in a computer-readable medium or transmitted as one or more instructions or code in a computer-readable medium. The computer-readable medium includes a computer storage medium and a communication medium. The communication medium includes any medium that facilitates transmission of a computer program from one place to another. The storage medium may be any available medium accessible to a general-purpose or special-purpose computer.

In the several embodiments provided in this application, it should be understood that the disclosed device and method may be implemented in other manners. For example, the described apparatus embodiment is merely an example. For example, division into the modules is merely logical function division and may be other division in an actual implementation. For example, a plurality of modules may be combined or integrated into another system, or some features may be ignored or not performed. In addition, the displayed or discussed mutual couplings or direct couplings or communication connections may be implemented through some interfaces. The indirect couplings or communication connections between the apparatuses or modules may be implemented in electronic, mechanical, or other forms.

The modules described as separate parts may or may not be physically separate, and parts displayed as units may or may not be physical units, may be located in one location, or may be distributed on a plurality of network units. Some or all the modules may be selected based on an actual requirement to achieve the objectives of the solutions of embodiments.

In addition, functional modules in embodiments of this application may be integrated into one processing unit, or each of the modules may exist alone physically, or two or more modules are integrated into one unit. The integrated unit may be implemented in a form of hardware, or may be implemented in a form of hardware in addition to a software functional unit.

The foregoing description is merely a specific implementation of this application, but is not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An encoding method, comprising:

   obtaining (S401) a to-be-encoded bit sequence;
   performing (S402) polar encoding on the to-be-encoded bit sequence to obtain a first bit sequence;
   performing (S403) convolutional encoding on the first bit sequence to obtain a second bit sequence; and
   outputting (S404) the second bit sequence;
   wherein the convolutional encoding is implemented by using a feedforward shift register, wherein the feedforward shift register comprises m registers and k taps, wherein k is an odd number; and wherein the m registers are initialized with the last m bits in the first bit sequence, wherein the length of the first bit sequence is n, the first bit sequence is $p = \{p_0, p_1, ........., p_{n-1}\}$, the last m bits in the first bit sequence are $p_{n-m-1}$ to $p_{n-1}$, and the m registers are initialized from left to right with the last m bits $p_{n-1}$ to $p_{n-m-1}$; and
   wherein a length of the second bit sequence is the same as the length of the first bit sequence.

2. The method according to claim 1, wherein each bit in the second bit sequence is obtained by performing a modulo-2 summation operation on bits extracted by the k taps;
   wherein the length of the first bit sequence is n>m; wherein an output bit $x_0$ is obtained by performing the modulo-2 summation operation on the bits extracted by the k taps; and the performing convolutional encoding on the first bit sequence to obtain a second bit sequence further comprises:

   performing an $i^{th}$ time of shift update on bits in the m registers based on a bit sequence in the first bit sequence, and performing the modulo-2 summation operation on the bits extracted by the k taps and obtained after the $i^{th}$ time of shift update, to obtain an output bit $x_i$ corresponding to the $i^{th}$ time of shift update, wherein i is successively 1, 2, ..., and n-1, and
   the second bit sequence is $x = \{x_0, x_1, x_2, ... , x_{n-1}\}$;
   wherein the performing an $i^{th}$ time of shift update on bits in the m registers based on a bit sequence in the first bit sequence comprises:
   shifting out the bit in the rightmost register, shifting the bits in the remaining registers by one bit to the right, and shifting the (i-1)th bit $p_{i-1}$ of the first bit sequence into the leftmost register.

3. The method according to any one of claims 1 to 2, wherein m is a positive integer greater than or equal to 5.

4. The method according to any one of claims 1 to 3, wherein the convolutional encoding is tail-biting convolutional encoding, and in a polynomial corresponding to the tail-biting convolutional encoding, the quantity of coefficients equal to 1 is an odd number.

5. An encoding apparatus (10), comprising:

   an obtaining module (11), configured to obtain a to-be-encoded bit sequence;
   a first encoding module (12), configured to perform polar encoding on the to-be-encoded bit sequence to obtain a first bit sequence;
   a second encoding module (13), configured to perform convolutional encoding on the first bit sequence to obtain a second bit sequence; and
   an output module (14), configured to output the second bit sequence;
   wherein the convolutional encoding is implemented by using a feedforward shift register, wherein the feedforward shift register comprises m registers and k taps, wherein k is an odd number; and wherein the m registers are initialized with the last m bits in the first bit sequence, wherein the length of the first bit sequence is n, the first bit

sequence is p = {$p_0$, $p_1$,........., $p_{n-1}$}, the last m bits in the first bit sequence are $p_{n-m-1}$ to $p_{n-1}$, and the m registers are initialized from left to right with the last m bits $p_{n-1}$ to $p_{n-m}$; and

wherein a length of the second bit sequence is the same as the length of the first bit sequence.

**6.** The apparatus according to claim 5, wherein each bit in the second bit sequence is obtained by performing a modulo-2 summation operation on bits extracted by the k taps;

wherein the length of the first bit sequence is n>m; wherein an output bit $x_0$ is obtained by performing the modulo-2 summation operation on the bits extracted by the k taps; and the second encoding module is specifically configured to:

perform an $i^{th}$ time of shift update on bits in the m registers based on a bit sequence in the first bit sequence, and perform the modulo-2 summation operation on the bits extracted by the k taps and obtained after the $i^{th}$ time of shift update, to obtain an output bit $x_i$ corresponding to the $i^{th}$ time of shift update, wherein i is successively 1, 2, ..., and n-1, and

the second bit sequence is x = {$x_0$, $x_1$, $x_2$, ... , $x_{n-1}$};

wherein to perform an $i^{th}$ time of shift update on bits in the m registers based on a bit sequence in the first bit sequence comprises:

shifting out the bit in the rightmost register, shifting the bits in the remaining registers by one bit to the right, and shifting the (i-1)th bit $p_{i-1}$ of the first bit sequence into the leftmost register.

**7.** A storage medium, wherein the storage medium is configured to store a computer program, and the computer program is used to implement the encoding method according to any one of claims 1 to 4.

**8.** A computer program product, comprising a computer program, wherein when the computer program is executed by a processor (21), the encoding method according to any one of claims 1 to 4 is implemented.

## Patentansprüche

**1.** Codierungsverfahren, das umfasst:

Erhalten (S401) einer zu codierenden Bitsequenz;

Durchführen (S402) einer Polarcodierung an der zu codierenden Bitsequenz, um eine erste Bitsequenz zu erhalten;

Durchführen (S403) einer Faltungscodierung an der ersten Bitsequenz, um eine zweite Bitsequenz zu erhalten; und

Ausgeben (S404) der zweiten Bitsequenz;

wobei die Faltungscodierung unter Verwendung eines Vorwärtsschieberegisters implementiert wird, wobei das Vorwärtsschieberegister m Register und k Abgriffe umfasst,

wobei k eine ungerade Zahl ist; und wobei die m Register mit den letzten m Bits in der ersten Bitsequenz initialisiert werden, wobei die Länge der ersten Bitsequenz n ist, die erste Bitsequenz p = {$p_0$, $p_1$,........., $p_{n-1}$} ist, die letzten m Bits in der ersten Bitsequenz $p_{n-m-1}$ bis $p_{n-1}$ sind und die m Register von links nach rechts mit den letzten m Bits $p_{n-1}$ bis $p_{n-m-1}$ initialisiert werden; und

wobei eine Länge der zweiten Bitsequenz gleich der Länge der ersten Bitsequenz ist.

**2.** Verfahren nach Anspruch 1, wobei jedes Bit in der zweiten Bitsequenz durch Durchführen einer Modulo-2-Summierungsoperation an durch die k Abgriffe extrahierten Bits erhalten wird;

wobei die Länge der ersten Bitsequenz n > m ist; wobei ein Ausgangsbit $x_0$ durch Durchführen der Modulo-2-Summierungsoperation an den durch die k Abgriffe extrahierten Bits erhalten wird und das Durchführen einer Faltungscodierung an der ersten Bitsequenz, um eine zweite Bitsequenz zu erhalten, ferner umfasst:

Durchführen eines i-ten Mals einer Verschiebungsaktualisierung an Bits in den m Registern basierend auf einer Bitsequenz in der ersten Bitsequenz und Durchführen der Modulo-2-Summierungsoperation an den durch die k Abgriffe extrahierten und nach dem i-ten Mal einer Verschiebungsaktualisierung erhaltenen Bits, um ein Ausgangsbit $x_i$ entsprechend dem i-ten Mal einer Verschiebungsaktualisierung zu erhalten, wobei i nacheinander 1, 2, ... und n-1 ist, und

die zweite Bitsequenz x = {$x_0$,$x_1$,$x_2$, ...,$x_{n-1}$} ist;

wobei das Durchführen eines i-ten Mals einer Verschiebungsaktualisierung an Bits in den m Registern basierend auf einer Bitsequenz in der ersten Bitsequenz umfasst:

Verschieben des Bits im äußersten rechten Register, Verschieben der Bits in den verbleibenden Registern um ein Bit nach rechts und Verschieben des (i-1)-ten Bits $p_{i-1}$ der ersten Bitsequenz in das äußerste linke Register.

3. Verfahren nach einem der Ansprüche 1 bis 2, wobei m eine positive ganze Zahl größer oder gleich 5 ist.

4. Verfahren nach einem der Ansprüche 1 bis 3, wobei die Faltungscodierung eine Tail-Biting-Faltungscodierung ist und in einem Polynom, das der Tail-Biting-Faltungscodierung entspricht, die Anzahl von Koeffizienten gleich 1 eine ungerade Zahl ist.

5. Codierungsvorrichtung (10), die umfasst:

ein Erhaltungsmodul (11), das konfiguriert ist, um eine zu codierende Bitsequenz zu erhalten;
ein erstes Codierungsmodul (12), das konfiguriert ist, um eine Polarcodierung an der zu codierenden Bitsequenz durchzuführen, um eine erste Bitsequenz zu erhalten;
ein zweites Codierungsmodul (13), das konfiguriert ist, um eine Faltungscodierung an der ersten Bitsequenz durchzuführen, um eine zweite Bitsequenz zu erhalten; und
ein Ausgabemodul (14), das konfiguriert ist, um die zweite Bitsequenz auszugeben;
wobei die Faltungscodierung unter Verwendung eines Vorwärtsschieberegisters implementiert wird, wobei das Vorwärtsschieberegister m Register und k Abgriffe umfasst, wobei k eine ungerade Zahl ist; und wobei die m Register mit den letzten m Bits in der ersten Bitsequenz initialisiert werden, wobei die Länge der ersten Bitsequenz n ist, die erste Bitsequenz p = {$p_0$, $p_1$,........., $p_{n-1}$} ist, die letzten m Bits in der ersten Bitsequenz $p_{n-m-1}$ bis $p_{n-1}$ sind und die m Register von links nach rechts mit den letzten m Bits $p_{n-1}$ bis $p_{n-m}$ initialisiert werden; und
wobei eine Länge der zweiten Bitsequenz gleich der Länge der ersten Bitsequenz ist.

6. Vorrichtung nach Anspruch 5, wobei jedes Bit in der zweiten Bitsequenz durch Durchführen einer Modulo-2-Summierungsoperation an durch die k Abgriffe extrahierten Bits erhalten wird;
wobei die Länge der ersten Bitsequenz n > m ist; wobei ein Ausgangsbit $x_0$ durch Durchführen der Modulo-2-Summierungsoperation an den durch die k Abgriffe extrahierten Bits erhalten wird und wobei das zweite Codierungsmodul speziell konfiguriert ist zum:

Durchführen eines i-ten Mals einer Verschiebungsaktualisierung an Bits in den m Registern basierend auf einer Bitsequenz in der ersten Bitsequenz und Durchführen der Modulo-2-Summierungsoperation an den durch die k Abgriffe extrahierten und nach dem i-ten Mal einer Verschiebungsaktualisierung erhaltenen Bits, um ein Ausgangsbit $x_i$ entsprechend dem i-ten Mal einer Verschiebungsaktualisierung zu erhalten, wobei i nacheinander 1, 2, ... und n-1 ist, und
die zweite Bitsequenz x = {$x_0$,$x_1$,$x_2$, ...,$x_{n-1}$} ist;
wobei das Durchführen eines i-ten Mals einer Verschiebungsaktualisierung an Bits in den m Registern basierend auf einer Bitsequenz in der ersten Bitsequenz umfasst:
Verschieben des Bits im äußersten rechten Register, Verschieben der Bits in den verbleibenden Registern um ein Bit nach rechts und Verschieben des (i-1)-ten Bits $p_{i-1}$ der ersten Bitsequenz in das äußerste linke Register.

7. Speicherungsmedium, wobei das lesbare Speicherungsmedium konfiguriert ist, um ein Computerprogramm zu speichern, und das Computerprogramm verwendet wird, um das Codierungsverfahren nach einem der Ansprüche 1 bis 4 zu implementieren.

8. Computerprogrammprodukt, das ein Computerprogramm umfasst, wobei, wenn das Computerprogramm durch einen Prozessor (21) ausgeführt wird, das Codierungsverfahren nach einem der Ansprüche 1 bis 4 implementiert wird.

**Revendications**

1. Procédé de codage, comprenant :

l'obtention (S401) d'une séquence de bits à coder ;
la réalisation (S402) d'un codage polaire sur la séquence de bits à coder pour obtenir une première séquence de bit ;

la réalisation (S403) d'un codage de convolution sur la première séquence de bits pour obtenir une seconde séquence de bits ; et

la sortie (S404) de la seconde séquence de bits ;

dans lequel le codage de convolution est mis en œuvre en utilisant un registre à décalage anticipé, dans lequel le registre à décalage anticipé comprend m registres et k prises, dans lequel k est un nombre impair ; et dans lequel les m registres sont initialisés avec les m derniers bits dans la première séquence de bits, dans lequel la longueur de la première séquence de bits est n, la première séquence de bits est $p = \{p_0, p_1, \ldots, p_{n-1}\}$, les m derniers bits dans la première séquence de bits sont $p_{n-m-1}$ à $p_{n-1}$, et les m registres sont initialisés de gauche à droite avec les m derniers bits $p_{n-1}$ à pn-m-1 ; et

dans lequel une longueur de la seconde séquence de bits est identique à la longueur de la première séquence de bits.

2. Procédé selon la revendication 1, dans lequel chaque bit dans la seconde séquence de bits est obtenu en réalisant une opération de sommation modulo-2 sur des bits extraits par les k prises ;

dans lequel la longueur de la première séquence de bits est n > m ; dans lequel un bit de sortie $x_0$ est obtenu en réalisant l'opération de sommation modulo-2 sur les bits extraits par les k prises ; et la réalisation d'un codage de convolution sur la première séquence de bits pour obtenir une seconde séquence de bits comprend en outre :

la réalisation d'une $i^{ème}$ fois de mise à jour de décalage sur des bits dans les m registres sur la base d'une séquence de bits dans la première séquence de bits, et la réalisation de l'opération de sommation modulo-2 sur les bits extraits par les k prises et obtenus après la $i^{ème}$ fois de mise à jour de décalage, pour obtenir un bit de sortie $x_i$ correspondant à la $i^{ème}$ fois de mise à jour de décalage, dans lequel i est successivement 1, 2, ..., et n-1, et la seconde séquence de bits est $x = \{x_0, x_1, x_2, \ldots, x_{n-1}\}$ ;

dans lequel la réalisation d'une $i^{ème}$ fois de mise à jour de décalage sur des bits dans les m registres sur la base d'une séquence de bits dans la première séquence de bits comprend :

le décalage du bit dans le registre le plus à droite, le décalage des bits dans les registres restants d'un bit vers la droite, et le décalage du (i-1)ème bit $p_{i-1}$ de la première séquence de bits dans le registre le plus à gauche.

3. Procédé selon l'une quelconque des revendications 1 à 2, dans lequel m est un entier positif supérieur ou égal à 5.

4. Procédé selon l'une quelconque des revendications 1 à 3, dans lequel le codage de convolution est un codage de convolution circulaire, et dans un polynôme correspondant au codage de convolution circulaire, la quantité de coefficients égale à 1 est un nombre impair.

5. Appareil de codage (10), comprenant :

un module d'obtention (11), configuré pour obtenir une séquence de bits à coder ;

un premier module de codage (12), configuré pour réaliser un codage polaire sur la séquence de bits à coder pour obtenir une première séquence de bits ;

un second module de codage (13), configuré pour réaliser un codage de convolution sur la première séquence de bits pour obtenir une seconde séquence de bits ; et

un module de sortie (14), configuré pour sortir la seconde séquence de bits ;

dans lequel le codage de convolution est mis en œuvre en utilisant un registre à décalage anticipé, dans lequel le registre à décalage anticipé comprend m registres et k prises, dans lequel k est un nombre impair ; et dans lequel les m registres sont initialisés avec les m derniers bits dans la première séquence de bits, dans lequel la longueur de la première séquence de bits est n, la première séquence de bits est $p = \{p_0, p_1, \ldots, p_{n-1}\}$, les m derniers bits dans la première séquence de bits sont $p_{n-m-1}$ à $p_{n-1}$, et les m registres sont initialisés de gauche à droite avec les m derniers bits $p_{n-1}$ à $p_{n-m}$ ; et

dans lequel une longueur de la seconde séquence de bits est identique à la longueur de la première séquence de bits.

6. Appareil selon la revendication 5, dans lequel chaque bit dans la seconde séquence de bits est obtenu en réalisant une opération de sommation modulo-2 sur des bits extraits par les k prises ;

dans lequel la longueur de la première séquence de bits est n > m ; dans lequel un bit de sortie $x_0$ est obtenu en réalisant l'opération de sommation modulo-2 sur les bits extraits par les k prises ; et le second module de codage est spécifiquement configuré pour :

réaliser une $i^{ème}$ fois de mise à jour de décalage sur des bits dans les m registres sur la base d'une séquence de bits dans la première séquence de bits, et réaliser l'opération de sommation modulo-2 sur les bits extraits par les k prises et obtenus après **la** $i^{\text{ème}}$ fois de mise à jour de décalage, pour obtenir un bit de sortie $x_i$ correspondant à la $i^{\text{ème}}$ fois de mise à jour de décalage, dans lequel i est successivement 1, 2, ..., et n-1, et

la seconde séquence de bits est $x = \{x_0, x_1, x_2, ..., x_{n-1}\}$ ;

dans lequel réaliser une $i^{\text{ème}}$ fois de mise à jour de décalage sur les bits dans les m registres sur la base d'une séquence de bits dans la première séquence de bits comprend :

le décalage du bit dans le registre le plus à droite, le décalage des bits dans les registres restants d'un bit vers la droite, et le décalage du (i-1)ème bit $p_{i-1}$ de la première séquence de bits dans le registre le plus à gauche.

7. Support de stockage, dans lequel le support de stockage est configuré pour stocker un programme informatique, et le programme informatique est utilisé pour mettre en œuvre le procédé de codage selon l'une quelconque des revendications 1 à 4.

8. Produit-programme informatique, comprenant un programme informatique, dans lequel lorsque le programme informatique est exécuté par un processeur (21), le procédé de codage selon l'une quelconque des revendications 1 à 4 est mis en œuvre.

Network device

Terminal device

| Encoding side | Channel | Decoding side |

FIG. 1

| Source | → | Source encoding | → | Channel encoding | → | Modulation and mapping |

Channel

| Destination | ← | Source decoding | ← | Channel decoding | ← | Demodulation and demapping |

FIG. 2

FIG. 3

FIG. 4

FIG. 5

FIG. 6

First bit sequence: $p = \{p_0, p_1, p_2, p_3, p_4, p_5, p_6, p_7\} = \{1, 1, 1, 0, 0, 0, 1, 1\}$

FIG. 7A

Tap 1

Tap 2

Shift $p_0$ in the first bit sequence to the register

Output bit: $x_1 = 0$

| 1 | 1 | 1 | 0 | 0 | 0 |

Register 1 · Register 2 · Register 3 · Register 4 · Register 5 · Register 6

Tap 3

FIG. 7B

Tap 1

Tap 2

Shift $p_1$ in the first bit sequence to the register

Output bit: $x_2 = 0$

| 1 | 1 | 1 | 1 | 0 | 0 |

Register 1 · Register 2 · Register 3 · Register 4 · Register 5 · Register 6

Tap 3

FIG. 7C

Tap 1

Tap 2

Shift $p_2$ in the first bit sequence to the register

Output bit: $x_3 = 0$

| 1 | 1 | 1 | 1 | 1 | 0 |

Register 1 · Register 2 · Register 3 · Register 4 · Register 5 · Register 6

Tap 3

FIG. 7D

Tap 1

Tap 2

Shift $p_3$ in the first bit sequence to the register

Output bit: $x_4 = 1$

| 0 | 1 | 1 | 1 | 1 | 1 |

Register 1 · Register 2 · Register 3 · Register 4 · Register 5 · Register 6

Tap 3

FIG. 7E

Tap 1

Tap 2

Output bit:
$x_5 = 0$

Shift $p_4$ in the
first bit sequence
to the register

| 0 | 0 | 1 | 1 | 1 | 1 |

Tap 3

Register 1 Register 2 Register 3 Register 4 Register 5 Register 6

FIG. 7F

Tap 1

Tap 2

Output bit:
$x_6 = 1$

Shift $p_5$ in the
first bit sequence
to the register

| 0 | 0 | 0 | 1 | 1 | 1 |

Tap 3

Register 1 Register 2 Register 3 Register 4 Register 5 Register 6

FIG. 7G

Tap 1

Tap 2

Output bit:
$x_7 = 1$

Shift $p_6$ in the
first bit sequence
to the register

| 1 | 0 | 0 | 0 | 1 | 1 |

Tap 3

Register 1 Register 2 Register 3 Register 4 Register 5 Register 6

FIG. 7H

FIG. 8

FIG. 9

To-be-encoded bit sequence → **Polar encoding** → First bit sequence → **Feedforward shift register** → Second bit sequence → **Rate matching** → Third bit sequence →

FIG. 10

FIG. 11

Encoding apparatus 10

Obtaining module — 11

First encoding module — 12

Second encoding module — 13

Output module — 14

FIG. 12

Encoding apparatus 20

Processor — 21

23

Memory — 22

FIG. 13

Encoding apparatus 30

32

31

Input interface

Logic circuit

33

Output interface

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **XIAO, FEI et al.** *A novel coded modulation scheme based on polar code*
- **MA, H.H. et al.** *On tail biting convolutional codes*
- **MAO, YINYOU et al.** *A serially concatenated coding scheme of polar code and the improved belief propagation decoding algorithm*